Europäisches Patentamt

**European Patent Office**

**Office européen des brevets**

(11) Numéro de publication : **0 064 904**
**B1**

# FASCICULE DE BREVET EUROPÉEN

(45) Date de publication du fascicule du brevet :
30.10.85

(51) Int. Cl.⁴ : **H 05 K  5/00,** H 05 K  7/18,
H 05 K  7/02

(21) Numéro de dépôt : **82400727.2**

(22) Date de dépôt : **23.04.82**

(54) **Armoire ou boîtier pour appareils électriques débrochables.**

(30) Priorité : 30.04.81 EP 81400681

(43) Date de publication de la demande :
17.11.82 Bulletin 82/46

(45) Mention de la délivrance du brevet :
30.10.85 Bulletin 85/44

(84) Etats contractants désignés :
BE DE FR LU NL

(56) Documents cités :
DE-A- 1 922 537
DE-A- 2 619 340
DE-B- 1 057 671
FR-A- 1 572 503
US-A- 3 977 749
US-A- 4 119 818

(73) Titulaire : Société Anonyme de Systèmes, Etudes et
Matériel Electrique et Mécanique du Nord en abrégé
MATERIEL ELECTRIQUE ET MECANIQUE DU NORD
33 rue Général de Gaulle B.P. 75
F-59139 Wattignies (FR)

(72) Inventeur : Pigot, André
16, Rue du 8 mai 1945
F-59175 Templemars (FR)

(74) Mandataire : Bossard, Franz et al
ACEC - Service des Brevets Boîte Postale 4
B-6000 Charleroi (BE)

Jouve, 18, rue St-Denis, 75001 Paris, France

## Description

La présente invention a pour objet une armoire ou un boîtier constitué d'un châssis fixe équipé de conducteurs d'amenée et de départ sur lesquels il est possible d'embrocher des appareils électriques débrochables, le châssis fixe présentant des moyens de localisation et de guidage pour un ou plusieurs appareils électriques ou un équipage mobile solidaire d'au moins un tel appareil électrique et supportant d'une part au moins un des appareils électriques et d'autre part au moins un dispositif de verrouillage, le déplacement duquel donne lieu à l'engagement d'un premier moyen de solidarisation dans une gâche, dent ou encoche du châssis fixe.

Un tel dispositif est connu de DE-A-1057671.

Dans de tels boîtiers ou armoires connus, les broches de raccordement traversent par exemple des ouvertures ménagées dans des parois de protection à l'intérieur de l'armoire ou du boîtier et des verrouillages sont prévus qui empêchent notamment qu'un appareil dans l'état enclenché puisse être embroché ou débroché. Ce genre d'armoire ou de boîtier nécessite en général des appareils électriques spécialement conçus pour ce but, ce qui constitue une solution relativement coûteuse.

Le but de l'invention est une armoire ou boîtier pour appareils électriques de grande série, non dotés de possibilités de verrouillage. Les appareils utilisables dans l'armoire ou le boîtier suivant l'invention sont à commande automatique et/ou manuelle et leur état enclenché ou déclenché est matérialisé par la position d'une manette de commande.

L'armoire ou boîtier suivant l'invention est caractérisé en ce que chacun des appareils électriques est muni d'une manette de commande, et en ce que le dispositif de verrouillage comprend un deuxième moyen de solidarisation coopérant avec au moins une des manettes de commande pour verrouiller la position par rapport au châssis d'au moins un appareil électrique, ou d'un équipage mobile solidaire de cet appareil.

L'invention est expliquée ci-dessous par rapport à deux exemples de forme d'exécution en se référant au dessin annexé.

La figure 1 du dessin est une vue en perspective d'une des logettes d'une armoire ou d'un boîtier suivant l'invention.

Les figures 2 et 3 sont deux vues en perspective d'un équipage mobile monté dans une autre armoire ou boîtier suivant l'invention et d'un détail de cet équipage.

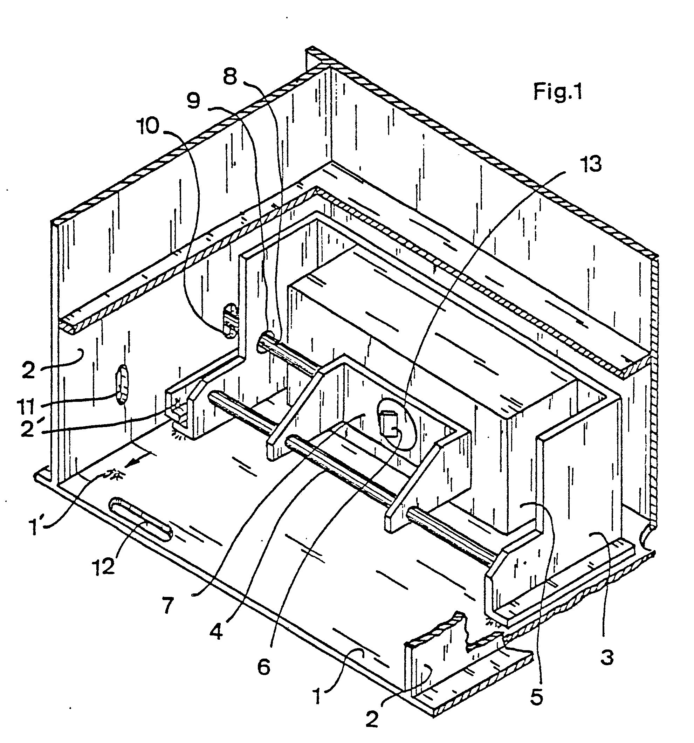

A la figure 1, un châssis fixe, partiellement coupé comprend une ou plusieurs logettes séparées l'une de l'autre par des tôles horizontales 1 et verticales 2. A l'intérieur de chaque logette, un équipage mobile coulisse sur une tôle horizontale 1. Chaque équipage mobile est composé d'un cadre 3 équipé d'une tringle de guidage 4. Il coulisse entre des bosses 1′ de la tôle 1 et des contre-rails 2′ solidaires des tôles 2. Le cadre 3 supporte un appareil électrique 5 dont la manette de commande 6 est solidarisée avec un dispositif de verrouillage composé par un étrier 7 coulissant sur la tringle 4 et muni d'un pêne de verrouillage 8 traversant un alésage 9 du cadre 3. La manette 6 est représentée dans l'état enclenché de l'appareil 5. L'équipage mobile se trouve en position embrochée c'est-à-dire en position de travail. Le pêne 8 est de ce fait engagé dans une gâche 10 d'une tôle 2 du châssis fixe. Dans l'état déclenché de l'appareil 5, le pêne 8 traverse toujours l'alésage 9, mais n'est pas engagé dans la gâche 10. De ce fait, l'équipage mobile peut être déplacé en direction de la flèche, ce qui a pour effet de débrocher l'appareil 5. Il est possible alors d'amener l'extrémité du pêne 8 en face d'une autre gâche 11 et la tringle 4 au-dessus d'un étrier 12. Dans cette position, l'appareil 5 est complètement débroché, de sorte qu'il est possible de tester à blanc c'est-à-dire sans courant, l'appareil 5, au moyen d'un ou plusieurs cadenas entourant la tringle 4 et traversant l'étrier 12, il est possible en outre de cadenasser l'appareil 5 en position débrochée.

Il est à remarquer que le châssis fixe se trouve à l'intérieur d'une armoire ou boîtier accessible de préférence par une porte frontale, non représentée, vitrée ou non. Une telle porte frontale protège l'appareillage qu'elle renferme non seulement des poussières ou vapeurs corrosives de l'ambiance extérieure, mais aussi de manipulations indues par des personnes qui n'ont pas autorité pour le faire.

L'espace à l'intérieur de l'armoire est prévu suffisamment vaste pour qu'en position débrochée, cadenassée de l'appareil 5, la porte de l'armoire ou du boîtier puisse être fermée. De préférence la porte est vitrée afin de permettre le contrôle immédiat des positions des manettes de commande, des positions embrochées ou débrochées des différents appareils ou le manque d'un appareil dans une logette.

La solidarisation de la manette de commande 6 avec l'étrier 7 du dispositif de verrouillage se fait par l'engagement de l'extrémité de cette manette 6 dans une ouverture ou œillet 13 approprié de cet étrier 7, éventuellement par l'intermédiaire d'un élément élastique, par exemple une membrane en caoutchouc sertie dans l'œillet 13.

L'embrochage de l'appareil 5 sur des conducteurs d'arrivée et de départ a lieu à travers des ouvertures, non visibles sur le dessin, dans la tôle verticale de fond. Cet embrochage relève d'une technique bien connue et ne fait pas partie de l'invention.

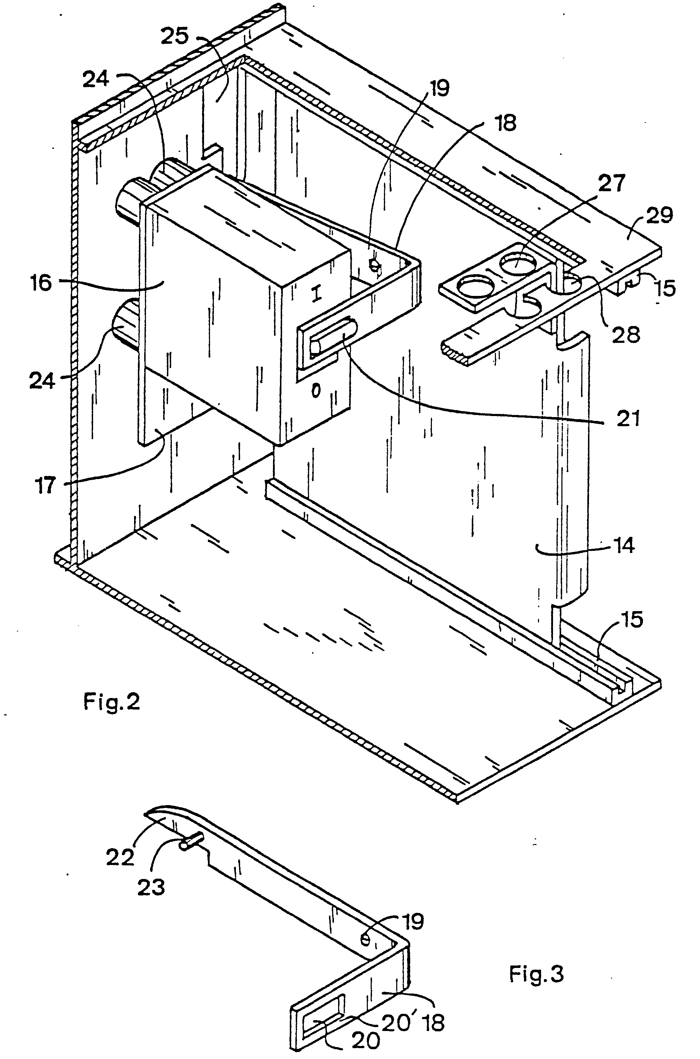

Les figures 2 et 3 représentent une armoire ou un boîtier suivant l'invention d'un agencement particulièrement simple et avantageux. En lieu et place d'un cadre 3 coulissant à l'intérieur d'une logette, une simple tôle verticale 14 à arêtes parallèles au-dessus et en dessous assume à la fois la fonction de cadre support et de paroi de séparation verticale d'une logette. La tôle 14 forme un équipage mobile coulissant dans des rails de guidage et de maintien 15, l'un au-dessus, l'autre en dessous. Elle supporte d'une part un appareil électrique 16 fixé sur une cornière 17 solidaire de la tôle 14 et d'autre part un dispositif de verrouillage 18 constitué par un simple levier pivotant autour d'un axe 19, solidaire de la tôle 14. Le levier 18 est montré détaché de la tôle 14 et de l'appareil 16 à la figure 3. Il comprend un bras de commande coudé et muni d'une fourche ou d'une ouverture 20 destinée à s'engager avec une extrémité d'une manette de commande 21 de l'appareil électrique 16 et un bras de verrouillage qui se termine par un bec 22 et un éperon 23 formant crochet.

L'appareil 16 est muni de broches 24 qui traversent la tôle verticale de fond pour s'engager sur des conducteurs d'arrivée et de départ, non visibles, disposés derrière celle-là. D'autres broches, non représentées, peuvent être prévues pour le raccordement de circuits de commande électriques automatiques de l'appareil 16. Dans l'état déclenché, la manette de commande 21 de l'appareil 16 est dirigée vers le bas et le bec 22 muni de son éperon 23 peut entrer par la partie large d'une encoche ou ouverture 25 en boutonnière dans la tôle 2 de fond. L'appareil 16 peut donc être embroché lorsque la manette de commande 21 se trouve en position déclenchée. L'embrochage se fait par simple déplacement de la tôle 14 dans ses rails de guidage et de maintien 15. Lorsque l'appareil 16 se trouve en position embrochée, la manette de commande 21 peut être relevée, c'est-à-dire être mise en position enclenchée. A ce moment, le bras de verrouillage s'abaisse dans la partie étroite de l'ouverture en boutonnière 25. Cette position est représentée à la figure 2 du dessin ; elle ne permet pas le débrochage de l'appareil à cause de l'éperon ou crochet 23 engagé dans la partie étroite de l'ouverture en boutonnière 25. Inversement, il n'est pas possible non plus d'embrocher l'appareil 16 lorsque celui-ci se trouve dans l'état enclenché, parce que l'éperon 23 ne peut pas s'introduire à travers la partie étroite de l'ouverture 25 en boutonnière. Le bec 22 du levier de verrouillage peut actionner un interrupteur de signalisation, non représenté.

Une équerre 26 munie de plusieurs trous 27 fixée à la tôle 14 est disposée en dessous d'une rangée de trous 28 dans une tôle de séparation d'étages 29 (partiellement coupée) lorsque l'appareil est en position débrochée. Il est possible de cadenasser cette position débrochée en engageant des cadenas à travers les trous 27 et 28 correspondants.

L'ouverture 20 du levier est représentée comme permettant juste l'engagement de la manette de commande 21. Ceci n'est pas indispensable. Il suffit de s'assurer que cette ouverture 20 exige le verrouillage de l'appareil 16 lorsque la manette de commande 21 se trouve en position enclenchée. Il est donc possible de concevoir l'extrémité du levier 18 qui s'engage avec la manette de commande 21 sous forme d'un étrier ou crochet ouvert vers le bras, en enlevant le pont 20' qui ferme l'ouverture 20. Une telle mesure est indiquée lorsque deux appareils électriques 16 sont montés côte à côte sur une même cornière 17 et lorsqu'un seul levier 18 s'engage avec les manettes de commande 21 des deux appareils 16. Dans ce cas un seul long crochet 20 s'étend sur les manettes de commande de deux appareils 16. Ceci a pour effet de commuter le levier 18 en position de verrouillage lorsqu'au moins une des manettes de commande est en position enclenchée et de n'admettre la position déverrouillée du levier 18 que lorsque toutes les deux manettes de commande 21 sont abaissées c'est-à-dire en position déclenchée. La même logique de verrouillage est assurée aussi pour un nombre quelconque d'appareils 16 montés côte à côte, tous agissant sur un même levier de verrouillage.

Il est utile de remarquer l'avantage particulier de l'exemple montré aux figures 2 et 3 vu la simplicité du montage et le fait que tous les mouvements d'embrochage et de verrouillage sont réalisés dans des directions parallèles au plan déterminé par les rails de guidage 15 ou au plan de la tôle 14. Il est possible ainsi de supprimer la nécessité de prévoir des parois de séparation latérales pour les logettes des appareils électriques embrochables, car ces parois de séparation sont constituées par les tôles 14 qui forment en même temps équipage mobile.

**Revendications**

1. Armoire ou boîtier constitué d'un châssis fixe (1, 2) équipé de conducteurs d'amenée et de départ sur lesquels il est possible d'embrocher des appareils électriques débrochables et de les verrouiller en position embrochée au moins si l'appareil électrique se trouve dans l'état enclenché, le châssis fixe présentant des moyens de localisation et de guidage (1, 2, 15) pour un ou plusieurs appareils électriques (5, 16) ou un équipage mobile (3, 14) solidaire d'au moins un tel appareil électrique (5, 16) et supportant d'une part au moins un des appareils électriques (5, 16) et d'autre part au moins un dispositif de verrouillage, le déplacement duquel donne lieu à l'engagement d'un premier moyen de solidarisation (8, 23) dans une gâche, dent ou encoche (10, 11, 25) du châssis fixe (1), caractérisé en ce que chacun des appareils électriques est muni d'une manette de commande (6, 21), et en ce que le dispositif de verrouillage comprend un deuxième moyen de solidarisation coopérant avec au moins une des manettes de commande (6, 21) pour verrouiller la position par rapport au châssis d'au moins un appareil électrique, ou d'un équipage mobile solidaire de cet appareil.

2. Armoire suivant la revendication 1, caractérisée en ce que le premier moyen de solidarisation est un crochet ou pêne et en ce que le deuxième moyen de solidarisation est une fourche, œillet ou étrier.

3. Armoire suivant une des revendications 1 ou 2, caractérisée en ce que un dispositif de verrouillage (7, 8, 18) est associé à chaque appareil électrique (5, 16) et solidarisé avec la manette de commande (6, 21) de celui-ci.

4. Armoire suivant une des revendications 1 ou 2, caractérisée en ce qu'un dispositif de verrouillage (7, 8, 18) est associé à un ensemble de plusieurs appareils électriques (16) et admet des positions différentes des manettes de commande en position verrouillée, mais n'admet que des positions déclenchées pour la position déverrouillée.

5. Armoire ou boîtier suivant une des revendications précédentes, caractérisée en ce qu'un équipage mobile en forme de cadre (3) coulisse entre des bosses et des contrerails solidaires des parois latérales (2) constituant des guides pour le cadre (3).

6. Armoire ou boîtier suivant la revendication 5, caractérisée en ce que le dispositif de verrouillage est constitué par un pêne (8) solidaire d'un étrier (7) engagé par un œillet (13) avec la manette de commande (6) de l'appareil électrique (5) et en ce que le pêne s'engage dans des gâches (10, 11) lorsque l'appareil électrique (5) se trouve dans l'état enclenché.

7. Armoire ou boîtier suivant une des revendications 1 à 4, caractérisée en ce qu'un équipage mobile en forme de tôle (14) à au moins deux arêtes parallèles est déplaçable dans deux rails (15) solidaires du châssis fixe dans lesquels sont engagés les deux arêtes parallèles.

8. Armoire ou boîtier suivant une des revendications 1 à 4 ou 7, caractérisée en ce que le dispositif de verrouillage est constitué d'un levier (18) pivotant autour d'un axe (19) solidaire de l'équipage mobile (14) et comprenant un bras de commande coudé muni d'une fourche ou ouverture (20) s'engageant avec une extrémité d'une manette de commande (21) de l'appareil électrique et un bras de verrouillage qui se termine par un éperon (23) formant crochet s'engageant dans une encoche ou ouverture en boutonnière (25) dans une tôle (2) du châssis fixe.

9. Armoire ou boîtier suivant une des revendications précédentes, caractérisée en ce que des étriers (4, 12) et/ou rangées de trous (27, 28) dans des éléments superposés en position débrochée de l'appareil électrique servent à l'introduction de cadenas pour cadenasser la position débrochée.

10. Armoire ou boîtier suivant une des revendications précédentes, caractérisée en ce qu'ils sont fermés par une porte qui interdit l'accès aux appareils et à leurs manettes de commande, même à l'état débroché.

**Claims**

1. Cabinet or housing comprising a fixed frame (1, 2) provided with input and output conductors to which it is possible to plug-in depluggable electrical apparatuses and lock them in the plugged-in position at least if the electrical apparatus is in the on state, the fixed frame having guiding and locating means (1, 2, 15) for one or more electrical apparatuses (5, 16) or a mobile unit (3, 14) integral with at least one such electrical apparatus (5, 16) and supporting on the one hand at least one of the electrical apparatuses (5, 16) and on the other hand at least one locking device, the displacement of which results in the engaging of a first securing means (8, 23) in a notch, indentation or slot (10, 11, 25) of the fixed frame (1), characterized in that each of the electrical apparatuses is provided with a control handle (6, 21), and in that the locking device comprises a second securing means co-operating with at least one of the control handles (6, 21) for locking the position relatively to the frame of at least one electrical apparatus, or of a mobile unit integral with this apparatus.

2. Cabinet according to claim 1, characterised in that the first securing means is a hook or bolt and in that the second securing means is a fork, eye, or stirrup.

3. Cabinet according to one of claims 1 or 2, characterised in that a locking device (7, 8, 18) is associated with each electrical apparatus (5, 16) and secured to the control handle (6, 21) of the latter.

4. Cabinet according to one of claims 1 or 2, characterised in that a locking device (7, 8, 18) is associated with a group of a plurality of electrical apparatuses (16) and allows various positions for the control handles in the locked position, but allows only off positions for the unlocked position.

5. Cabinet or housing according to one of the preceding claims, characterised in that a mobile unit in the form of a frame (3) slides between bosses and counterrails integral with the lateral walls (2) constituting guides for the frame (3).

6. Cabinet or housing according to claim 5, characterised in that the locking device comprises a bolt (8) integral with a stirrup (7) engaged by an eye (13) with the control handle (6) of the electrical apparatus (5) and in that the bolt engages in openings (10, 11) when the electrical apparatus (5) is in the on state.

7. Cabinet or housing according to one of claims 1 to 4, characterised in that a mobile unit in the form of a metal plate (14) with at least two parallel edges is adapted to be moved in two rails (15) integral with the fixed frame, said rails being engaged by the two parallel edges.

8. Cabinet or housing according to one of claims 1 to 4 or 7, characterised in that the locking device is constituted by a lever (18) pivoting about a pivot (19) integral with the mobile unit (14) and comprising an elbowed control arm provided with a fork or aperture (20) engaging with one end of a control handle (21) of the electrical apparatus, and a locking arm which terminates in a stud (23) forming a hook engaging in a slot or aperture of elongated form (25) in a metal plate (2) of the fixed frame.

9. Cabinet or housing according to one of the preceding claims, characterised in that stirrups (4, 12) and/or rows of holes (27, 28) in superposed elements in the deplugged position of the electrical apparatus serve for introduction of padlocks for padlocking the deplugged position.

10. Cabinet or housing according to one of the preceding claims, characterised in that they are closed by a door which prevents access to the apparatuses and to their control handles, even in the deplugged state.

## Patentansprüche

1. Schrank oder Gehäuse, aus einem festen Chassis (1, 2), das mit Eingangs- und Ausgangsleitern ausgerüstet ist, in die steckbare elektrische Geräte eingesteckt werden können, die zumindest in dem eingeschalteten Zustand in der eingesteckten Position verriegelt werden können, wobei das feste Chassis Positionierungs- und Führungsmittel (1', 2', 15) für ein oder mehrere elektrische Geräte (5, 16) oder für eine mit mindestens einem solchen elektrischen Gerät (5, 16) fest verbundene mobile Ausrüstung (3, 14) aufweist, und diese mobile Ausrüstung (3, 14) einerseits mindestens eines der elektrischen Geräte (5, 16) und andererseits mindestens eine Verriegelungsvorrichtung trägt, und wobei bei Verschiebung dieser Verriegelungsvorrichtung ein erstes Koppelungsmittel (8, 23) in eine Schließkappe, einen Zahn oder eine Aussparung (10, 11, 25) des festen Chassis (1, 2) eingreift, dadurch gekennzeichnet, daß jedes der elektrischen Geräte mit einem Steuerhebel (6, 21) versehen ist, und daß die Verriegelungsvorrichtung ein mit mindestens einem der Steuerhel (6, 21) zusammenwirkendes, zweites Koppelungsmittel aufweist, um die Position von mindestens einem elektrischen Gerät oder einer mit diesem elektrischen Gerät fest verbundenen mobilen Ausrüstung bezüglich des Chassis zu verriegeln.

2. Schrank gemäß Anspruch 1, dadurch gekennzeichnet, daß das erste Koppelungsmittel ein Haken oder Riegel ist, und daß das zweite Koppelungsmittel eine Gabel, eine Öse oder ein Bügel ist.

3. Schrank gemäß einem der Ansprüche 1 oder 2, dadurch gekennzeichnet, daß eine Verriegelungsvorrichtung (7, 8, 18) für jedes elektrische Gerät (5, 16) vorgesehen ist und mit dem Steuerhebel (6, 21) dieses Gerätes (5, 16) gekoppelt ist.

4. Schrank gemäß einem der Ansprüche 1 oder 2, dadurch gekennzeichnet, daß eine Verriegelungsvorrichtung (7, 8, 18) mit einer Gesamtheit von mehreren elektrischen Geräten (5, 16) gekoppelt ist, und in der verriegelten Position verschiedene Positionen der Steuerhebel zuläßt, aber in der entriegelten Position nur ausgeschaltete Positionen zuläßt.

5. Schrank oder Gehäuse gemäß einem der vorhergehenden Ansprüche, dadurch gekennzeichnet, daß eine mobile Ausrüstung in Form eines Rahmens (3) zwischen Erhebungen und Gegenschienen gleitet, wobei diese Gegenschienen mit den Seitenwänden (2) fest verbunden sind, und die Erhebungen und Gegenschienen Führungen für den Rahmen (3) darstellen.

6. Schrank oder Gehäuse gemäß Anspruch 5, dadurch gekennzeichnet, daß die Verriegelungsvorrichtung aus einem Riegel (8) besteht, der mit einem Bügel (7) fest verbunden ist, der über eine Öse (13) mit dem Steuerhebel (6) des elektrischen Gerätes (5) gekoppelt ist, und daß der Riegel (8) in Schließkappen (10, 11) eingreift, wenn sich das elektrische Gerät (5) in dem eingeschalteten Zustand befindet.

7. Schrank oder Gehäuse gemäß einem der Ansprüche 1 bis 4, dadurch gekennzeichnet, daß eine mobile Ausrüstung in Form eines Blechs (14) mit mindestens zwei parallelen Kanten in zwei mit dem festen Chassis fest verbundenen Schienen (15) verschiebbar ist, in die die zwei parallelen Kanten eingreifen.

8. Schrank oder Gehäuse gemäß einem der Ansprüche 1 bis 4 oder 7, dadurch gekennzeichnet, daß die Verriegelungsvorrichtung aus einem Hebel (18) besteht, der um eine mit der mobilen Ausrüstung (14) fest verbundene Achse (19) schwenkbar ist, und einen abgewinkelten Steuerarm aufweist, der mit einer Gabel oder Öffnung (20) versehen ist, die mit einem Ende eines Steuerhebels (21) des elektrischen Gerätes gekoppelt ist, und außerdem einen Verriegelungsarm aufweist, der am Ende mit einem Sporn (23) versehen ist, der in eine Aussparung oder längliche Öffnung (25) in einem Blech (2) des festen Chassis eingreift.

9. Schrank oder Gehäuse gemäß einem der vorhergehenden Ansprüche, dadurch gekennzeichnet, daß Bügel (4, 12) und/oder Lochreihen (27, 28) in Elementen, die in der herausgezogenen Position des elektrischen Gerätes übereinander angeordnet sind, zur Anbringung von Hängeschlössern dienen, um die herausgezogene Position zu sichern.

10. Schrank oder Gehäuse gemäß einem der vorhergehenden Ansprüche, dadurch gekennzeichnet, daß der Schrank oder das Gehäuse durch eine Türe verschlossen ist, die selbst im herausgezogenen Zustand den Zugang zu den Geräten und ihren Steuerhebeln verhindert.

Fig.1

**Fig.2**

**Fig.3**